# EUROPEAN PATENT APPLICATION

(11) **EP 3 614 429 A1**
(43) Date of publication of application: **26.02.2020**
(21) Application number: 19190809.4
(22) Date of filing: 08.08.2019
(51) Int. Cl.: H01L 27/02, H01L 21/761, H01L 27/092, H01L 21/8238

(54) **SEMICONDUCTOR DEVICE HAVING NOISE ISOLATION BETWEEN POWER REGULATOR CIRCUIT AND ELECTROSTATIC DISCHARGE CLAMP CIRCUIT**

(30) Priority: 21.08.2018 US 201862720163 P; 02.08.2019 US 201916529831
(71) Applicant: MediaTek Inc., Hsin-Chu 300 (TW)
(72) Inventor: CHEN, Shih-Fan, 30078 Hsin-Chu (TW); HSU, Kuo-Chun, 30078 Hsin-Chu (TW); LAI, Tai-Hsiang, 30078 Hsin-Chu (TW)
(74) Representative: Haseltine Lake Kempner LLP

(57) **Abstract**

A semiconductor device includes a P-type substrate, a first isolation region, a plurality of first N-well walls, and an electrostatic discharge (ESD) clamp circuit. The first isolation region is formed within the P-type substrate. The ESD clamp circuit is arranged to discharge ESD current upon detection of an ESD event, and includes a clamping component that is arranged to provide a discharge path for the ESD current. The clamping component is formed on a region wrapped in the first isolation layer and the first N-well walls.

## Description

This application claims the benefit of U.S. provisional application No. 62/720,163, filed on 08/21/2018.

### Background

The present invention relates to a semiconductor device, and more particularly, to a semiconductor device having noise isolation between a power regulator circuit and an electrostatic discharge (ESD) clamp circuit.

Electrostatic discharge (ESD) is a phenomenon that releases and transfers charges between a semiconductor device (e.g., a semiconductor chip) and an external object (e.g., a human body). Due to a large amount of charges being released in a short time, the energy from ESD is much higher than the bearing capacity of the semiconductor device, which may result in a temporary functional failure or even a permanent damage to the semiconductor device. Therefore, an ESD clamp circuit is provided in the semiconductor device to offer an electrostatic discharge path for protecting the semiconductor device effectively, so that the reliability and service life of the semiconductor device can be improved.

The ESD clamp circuit may include an ESD detection circuit and a clamping component. The ESD detection circuit is used to detect occurrence of an ESD event. When an ESD event is detected by the ESD detection circuit, the ESD detection circuit triggers the clamping component to enable a discharge path for conducting the ESD current. Ideally, the clamping component is not triggered unless an ESD event is detected by the ESD detection circuit, and should be off under a normal operation of the semiconductor device. However, there may be undesirable noise and inrush current on the power/ground mesh and even in the substrate to induce false triggering of the clamping component in the ESD clamp circuit.

Thus, there is a need for an innovative noise isolation design that is capable of protecting the clamping component in the ESD clamp circuit from undesirable noise.

### Summary

One of the objectives of the claimed invention is to provide a semiconductor device having noise isolation between a power regulator circuit and an electrostatic discharge (ESD) clamp circuit.

According to a first aspect of the present invention, an exemplary semiconductor device is disclosed. The exemplary semiconductor device includes a P-type substrate, a first isolation region, and an electrostatic discharge (ESD) clamp circuit. The first isolation region is formed within the P-type substrate. The ESD clamp circuit is arranged to discharge ESD current upon detection of an ESD event, and includes a clamping component that is arranged to provide a discharge path for the ESD current. The clamping component is formed on a region wrapped in the first isolation layer and the first N-well walls.

According to a second aspect of the present invention, an exemplary semiconductor device is disclosed. The exemplary semiconductor device includes a P-type substrate, an isolation region, a plurality of N-well walls, and a power regulator circuit. The isolation region is formed within the P-type substrate. The power regulator circuit is arranged to generate a regulated voltage output. The power regulator circuit includes an active component that is formed on a region wrapped in the isolation layer and the N-well walls.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a semiconductor device without noise isolation between a power regulator circuit and an electrostatic discharge (ESD) clamp circuit according to an embodiment of the present invention.
FIG. 2 is a diagram illustrating a cross section of a semiconductor structure of the semiconductor device shown in FIG. 1.
FIG. 3 is a diagram illustrating a first semiconductor device with noise isolation between a power regulator circuit and an ESD clamp circuit according to an embodiment of the present invention.
FIG. 4 is a diagram illustrating a cross section of a first semiconductor structure of the semiconductor device shown in FIG. 3.
FIG. 5 is a diagram illustrating a cross section of a second semiconductor structure of the semiconductor device shown in FIG. 3.
FIG. 6 is a diagram illustrating a second semiconductor device with noise isolation between a power regulator circuit and an ESD clamp circuit according to an embodiment of the present invention.
FIG. 7 is a diagram illustrating a cross section of a semiconductor structure of the semiconductor device shown in FIG. 6.
FIG. 8 is a diagram illustrating a third semiconductor device with noise isolation between a power regulator circuit and an ESD clamp circuit according to an embodiment of the present invention.
FIG. 9 is a diagram illustrating a cross section of a semiconductor structure of the semiconductor device shown in FIG. 8.
FIG. 10 is a diagram illustrating a first alternative design of a power regulator circuit according to an embodiment of the present invention.
FIG. 11 is a diagram illustrating a second alternative design of a power regulator circuit according to an embodiment of the present invention.
FIG. 12 is a diagram illustrating a third alternative design of a power regulator circuit according to an embodiment of the present invention.
FIG. 13 is a diagram illustrating a fourth alternative design of a power regulator circuit according to an embodiment of the present invention.
FIG. 14 is a diagram illustrating a first alternative design of an output stage used by a power regulator circuit according to an embodiment of the present invention.

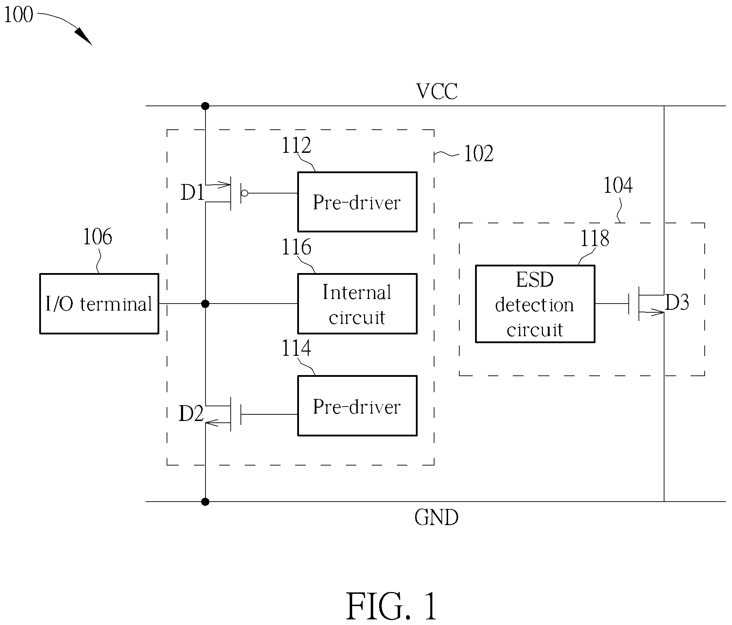

FIG. 1 5 is a diagram illustrating a second alternative design of an output stage used by a power regulator circuit according to an embodiment of the present invention.

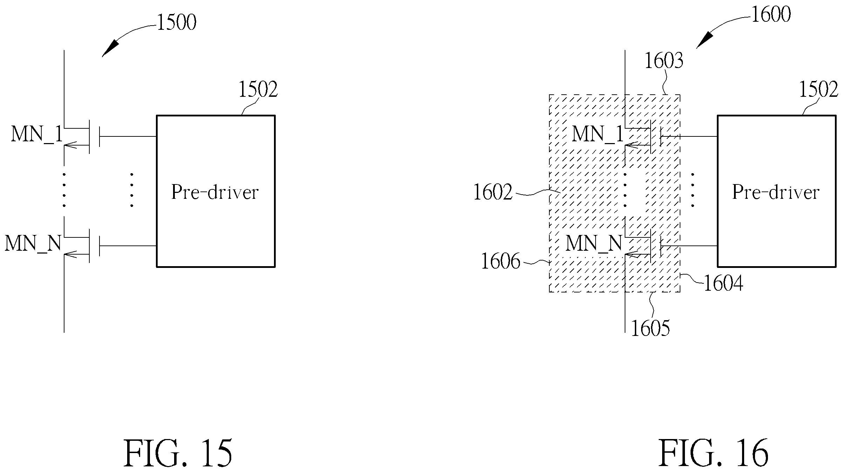

FIG. 16 is a diagram illustrating a third alternative design of an output stage used by a power regulator circuit according to an embodiment of the present invention.

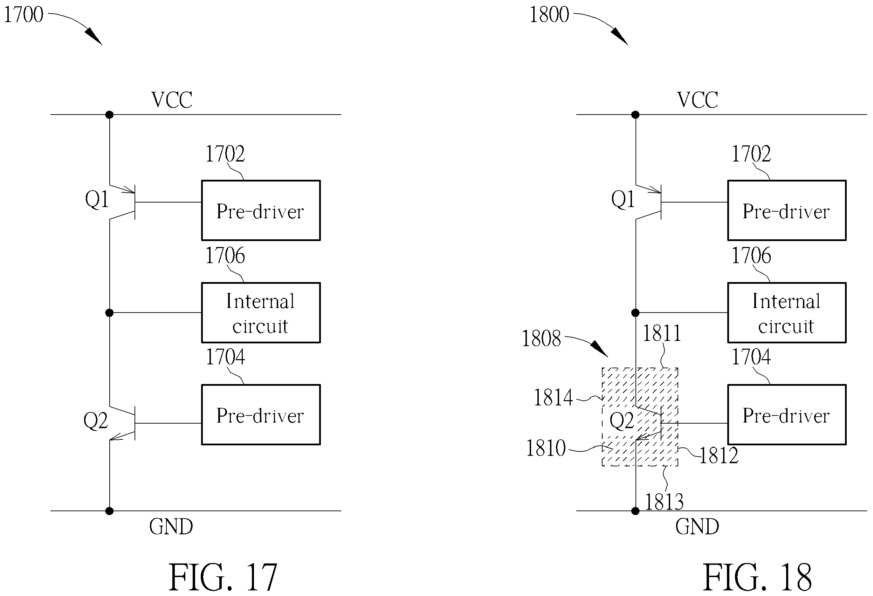

FIG. 17 is a diagram illustrating a fifth alternative design of a power regulator circuit according to an embodiment of the present invention.
FIG. 18 is a diagram illustrating a sixth alternative design of a power regulator circuit according to an embodiment of the present invention.

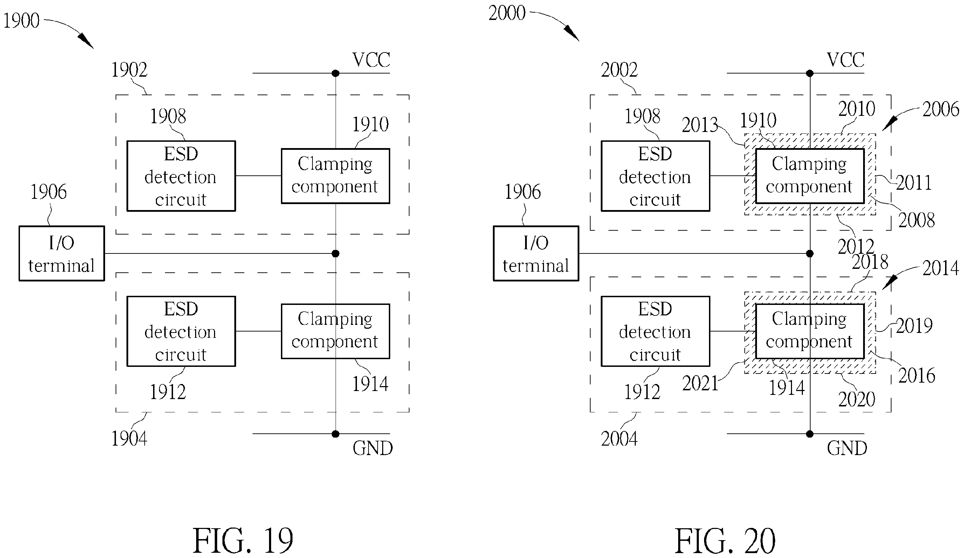

FIG. 19 is a diagram illustrating a first semiconductor device having at least one ESD clamp circuit coupled between an I/O terminal and a power rail according to an embodiment of the present invention.
FIG. 20 is a diagram illustrating a second semiconductor device having at least one ESD clamp circuit coupled between an I/O terminal and a power rail according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

FIG. 1 is a diagram illustrating a semiconductor device without noise isolation between a power regulator circuit and an electrostatic discharge (ESD) clamp circuit according to an embodiment of the present invention. The semiconductor device 100 is a semiconductor chip including a power regulator circuit 102, an ESD clamp circuit 104, and other circuits (not shown). The power regulator circuit 102 is arranged to generate a regulated voltage output. For example, the power regulator circuit 102 may be a low-dropout regulator (LDO) circuit. As shown in FIG. 1, the power regulator circuit 102 includes output stages (which are implemented by transistors D1 and D2), driving circuits (e.g., pre-drivers 112 and 114), and an internal circuit 116. In this example, the transistor D1 is a P-channel metal-oxide-semiconductor field-effect transistor (PMOS transistor) having a source terminal coupled to a power rail VCC, a gate terminal coupled to the pre-driver 112, and a drain terminal coupled to an input/output (I/O) terminal 106. In addition, the transistor D2 is an N-channel metal-oxide-semiconductor field-effect transistor (NMOS transistor) having a drain terminal coupled to the I/O terminal 106, a gate terminal coupled to the pre-driver 114, and a source terminal coupled to a power rail GND. The power rail VCC is used to provide a supply voltage, and the power rail GND is used to provide a ground voltage. In addition, the I/O terminal 106 is an I/O pad of the semiconductor chip.

The ESD clamp circuit 104 is implemented in the semiconductor chip for ESD protection. Specifically, the ESD clamp circuit 104 is arranged to discharge ESD current upon detection of an ESD event. As shown in FIG. 1, the ESD clamp circuit 104 includes an ESD detection circuit 118 and a clamping component (which is implemented by a transistor D3). In this embodiment, the transistor D3 is an NMOS transistor having a drain terminal coupled to the power rail VCC, a gate terminal coupled to the ESD detection circuit 118, and a source terminal coupled to the power rail GND. When an ESD event is detected by the ESD detection circuit 118, the ESD detection circuit 118 triggers the clamping component, such that the transistor D3 is turned on to provide a discharge path between the power rails VCC and GND for conducting the ESD current.

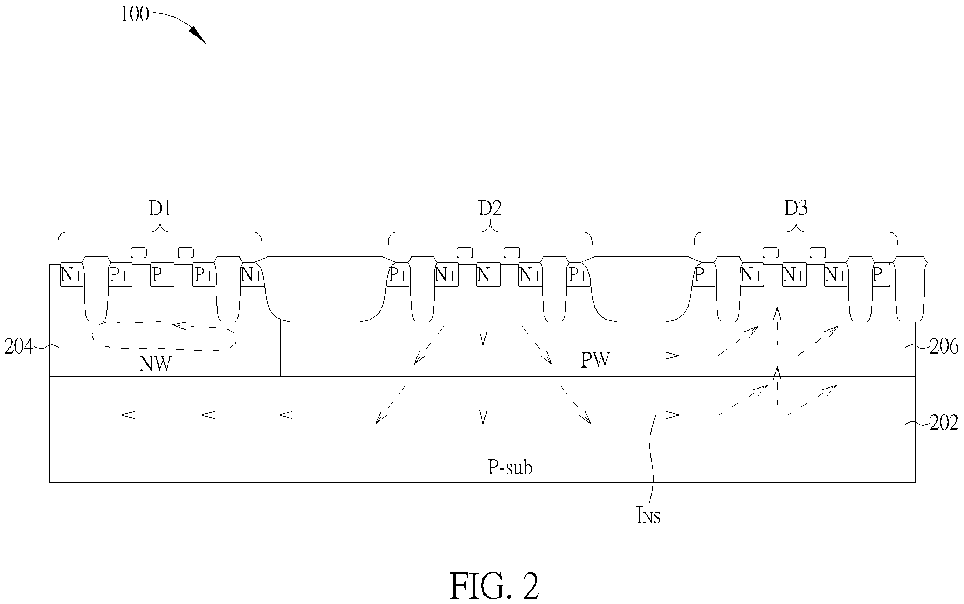

When the power regulator circuit 102 is operating under a switching frequency, the transistor D2 of the power regulator circuit 102 may cause undesirable noise and inrush current on power rails VCC, GND and even in a substrate to induce false triggering that turns on transistor D3 (or parasitic device of transistor D3) of the ESD clamp circuit 104. FIG. 2 is a diagram illustrating a cross section of a semiconductor structure of the semiconductor device 100 shown in FIG. 1. The semiconductor device 100 has a P-type substrate (denoted by "P-Sub") 202, an N-well (denoted by "NW") 204 formed on the P-type substrate 202, and a P-well (denoted by "PW") 204 formed on the P-type substrate 202. The transistor D1 is a PMOS transistor formed on the N-well 204. Both of the transistors D2 and D3 are NMOS transistors formed on the P-well 206. The transistor D2 causes noisy current I_{NS} due to the switching frequency of the power regulator circuit 102. As shown in FIG. 2, the noisy current I_{NS} flows into P-well 206 and P-type substrate 202. As a result, the noisy current I_{NS} would affect the transistor D3 and its parasitic device (e.g., parasitic bipolar junction transistor) to be turned on, thus inducing latch-up or undesirable current.

To address the above issue, the present invention proposes a semiconductor device with noise isolation between a power regulator circuit and an ESD clamp circuit. The proposed noise isolation technique is capable of protecting a clamping component in an ESD clamp circuit from undesirable noisy current caused by active component(s) in a power regulator circuit. Further details of the proposed noise isolation technique are described with reference to the accompanying drawings.

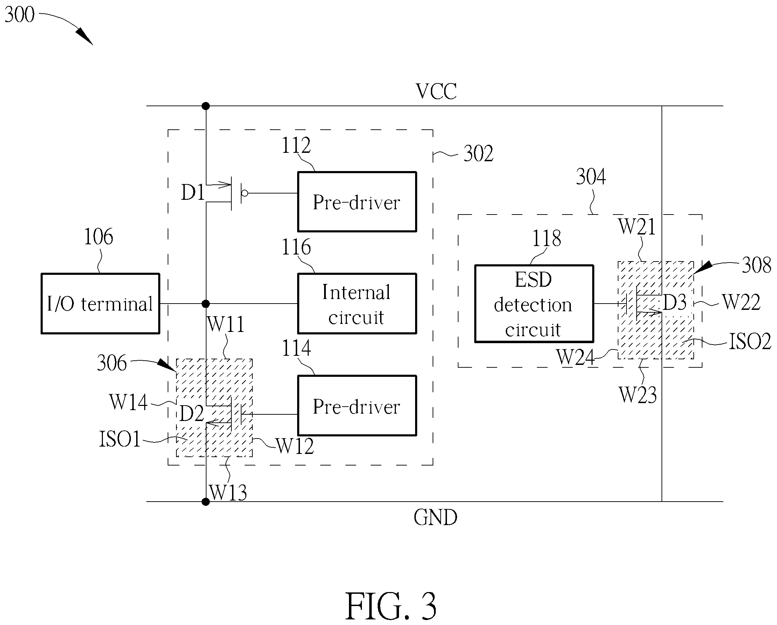

FIG. 3 is a diagram illustrating a first semiconductor device with noise isolation between a power regulator circuit and an ESD clamp circuit according to an embodiment of the present invention. The semiconductor device 300 is a semiconductor chip including a power regulator circuit 302, an ESD clamp circuit 304, and other circuits (not shown). The major difference between the semiconductor devices 100 and 300 is that the transistor D2 of the power regulator circuit 302 is protected by a proposed noise isolation structure 306 composed of an isolation region ISOl and a plurality of N-well walls W11, W12, W13, W14, and the transistor D3 of the ESD clamp circuit 304 is protected by a proposed noise isolation structure 308 composed of an isolation region ISO2 and a plurality of N-well walls W21, W22, W23, W24.

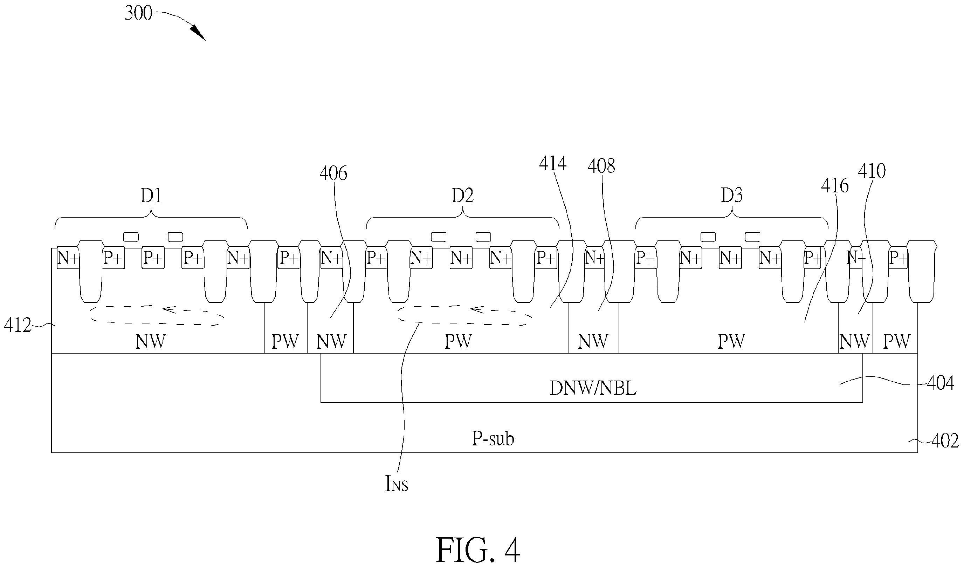

Please refer to FIG. 3 in conjunction with FIG. 4. FIG. 4 is a diagram illustrating a cross section of a first semiconductor structure of the semiconductor device 300 shown in FIG. 3. FIG. 3 shows a top view of the noise isolation structures 306 and 308, while FIG. 4 shows a sectional view of the noise isolation structures 306 and 308. As shown in FIG. 4, the semiconductor device 300 has a P-type substrate (denoted by "P-Sub") 402, an isolation region (denoted by "DNW/NBL") 404 formed within the P-type substrate 402, a plurality of N-well walls (denoted by "NW") 406, 408, 410, an N-well (denoted by "NW") 412 formed on the P-type substrate 402, and a plurality of P-wells (denoted by "PW") 414, 416 formed on the P-type substrate 402. The isolation region 404 may be a deep N-well or an N-type buried layer, depending upon the actual semiconductor process considerations. The transistor D1 is a PMOS transistor formed on the N-well 412. The transistor D2 is an NMOS transistor formed on the P-well 414. The transistor D3 is an NMOS transistor formed on the P-well 416.

In accordance with the first semiconductor structure, the isolation region ISOl of the transistor D2 and the isolation region ISO2 of the transistor D3 are realized by a single isolation region 404, and N-well walls W11-W14 of the transistor D2 and N-well walls W21-W24 of the transistor D3 have at least one common N-well wall (e.g., N-well wall 408) shared by the noise isolation structures 306 and 308.

The P-well 414 is formed on the isolation region 404, and is surrounded by N-well walls W11-W14, where the N-well wall 406 shown in FIG. 4 is one of the N-well walls W11-W14 shown in FIG.3, and the N-well wall 408 shown in FIG. 4 is another of the N-well walls W11-W14 shown in FIG. 3. Hence, the transistor D2 is formed on a region (i.e., P-well 414) that is wrapped in the isolation region 404 and the N-well walls W11-W14.

The P-well 416 is formed on the isolation region 404, and is surrounded by N-well walls W21-W24, where the N-well wall 408 shown in FIG. 4 is one of the N-well walls W21-W24 shown in FIG. 3, and the N-well wall 410 shown in FIG. 4 is another of the N-well walls W21-W24 shown in FIG. 3. Hence, the transistor D3 is formed on a region (i.e., P-well 416) that is wrapped in the isolation region 404 and the N-well walls W21-W24.

The transistor D2 causes noisy current I_{NS} due to the switching frequency of the power regulator circuit 302. Since the transistor D2 is protected by the noise isolation structure 306 due to the P-well 414 wrapped in the isolation region 404 and the N-well walls W11-W14, the noisy current I_{NS} is locked within the P-well 414 without leaking to the P-type substrate 402 and the P-well 416. Moreover, since the transistor D3 is protected by the noise isolation structure 308 due to the P-well 416 wrapped in the isolation region 404 and the N-well walls W21-W24, there is no noisy current allowed to enter the P-well 416 from adjacent P-well and/or adjacent P-type substrate. In this way, optimum ESD false-triggering prevention can be achieved by the noise isolation structures 306 and 308 implemented in the first semiconductor structure shown in FIG. 4.

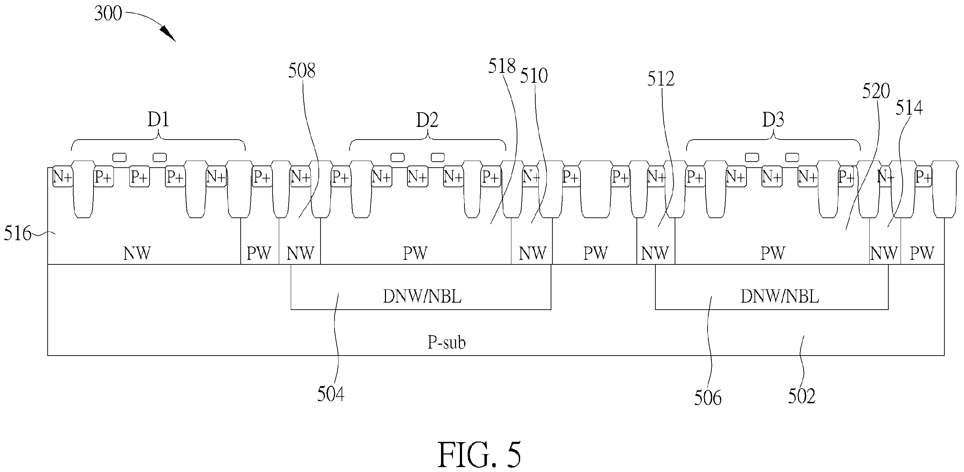

The semiconductor structure shown in FIG. 4 is for illustrative purposes only, and is not meant to be a limitation of the present invention. In practice, the noise isolation structures 306 and 308 may be realized in a different semiconductor structure. Please refer to FIG. 3 in conjunction with FIG. 5. FIG. 5 is a diagram illustrating a cross section of a second semiconductor structure of the semiconductor device 300 shown in FIG. 3. FIG. 3 shows a top view of the noise isolation structures 306 and 308, while FIG. 5 shows a sectional view of the noise isolation structures 306 and 308. As shown in FIG. 5, the semiconductor device 300 has a P-type substrate (denoted by "P-Sub") 502, a plurality of isolation regions (denoted by "DNW/NBL") 504, 506 formed within the P-type substrate 502, a plurality of N-well walls (denoted by "NW") 508, 510, 512, 514, an N-well (denoted by "NW") 516 formed on the P-type substrate 502, and a plurality of P-wells (denoted by "PW") 518, 520 formed on the P-type substrate 502. The isolation regions 504 and 506 may be deep N-wells or N-type buried layers, depending upon the actual semiconductor process considerations. The transistor D1 is a PMOS transistor formed on the N-well 516. The transistor D2 is an NMOS transistor formed on the P-well 518. The transistor D3 is an NMOS transistor formed on the P-well 520.

In accordance with the second semiconductor structure, the isolation region ISOl of the transistor D2 and the isolation region ISO2 of the transistor D3 are realized by separate isolation regions 504 and 506, and N-well walls W11-W14 of the transistor D2 and N-well walls W21-W24 of the transistor D3 have no common N-well wall shared by the noise isolation structures 306 and 308.

The P-well 518 is formed on the isolation region 504, and is surrounded by N-well walls W11-W14, where the N-well wall 508 shown in FIG. 5 is one of the N-well walls W11-W14 shown in FIG. 3, and the N-well wall 510 shown in FIG. 5 is another of the N-well walls W11-W14 shown in FIG. 3. Hence, the transistor D2 is formed on a region (i.e., P-well 518) wrapped in the isolation region 504 and the N-well walls W11-W14.

The P-well 520 is formed on the isolation region 506, and is surrounded by N-well walls W21-W24, where the N-well wall 512 shown in FIG. 5 is one of the N-well walls W21-W24 shown in FIG. 3, and the N-well wall 514 shown in FIG. 5 is another of the N-well walls W21-W24 shown in FIG. 3. Hence, the transistor D3 is formed on a region (i.e., P-well 520) wrapped in the isolation region 506 and the N-well walls W21-W24.

The transistor D2 causes noisy current I_{NS} due to the switching frequency of the power regulator circuit 302. Since the transistor D2 is protected by the noise isolation structure 306 due to the P-well 518 wrapped in the isolation region 504 and the N-well walls W11-W14, the noisy current is locked within the P-well 518 without leaking to the P-type substrate 502 and the P-well 520. Moreover, since the transistor D3 is protected by the noise isolation structure 308 due to the P-well 520 wrapped in the isolation region 506 and the N-well walls W21-W24, there is no noisy current allowed to enter the P-well 520 from adjacent P-well and/or adjacent P-type substrate. In this way, optimum ESD false-triggering prevention can be achieved by the noise isolation structures 306 and 308 implemented in the second semiconductor structure shown in FIG. 5.

The semiconductor device 300 has optimum ESD false-triggering prevention by providing the transistor D2 with the noise isolation structure 306 and providing the transistor D3 with the noise isolation structure 308. However, this is for illustrative purposes only, and is not meant to be a limitation of the present invention. Alternatively, a semiconductor device can have suboptimum ESD false-triggering prevention by providing only one of the transistors D2 and D3 with a noise isolation structure.

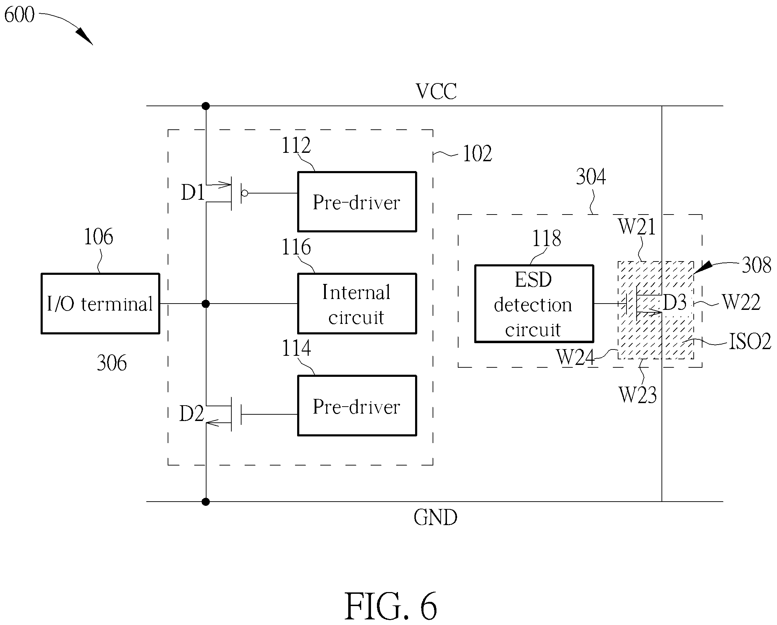

FIG. 6 is a diagram illustrating a second semiconductor device with noise isolation between a power regulator circuit and an ESD clamp circuit according to an embodiment of the present invention. The semiconductor device 600 is a semiconductor chip including the power regulator circuit 102, the ESD clamp circuit 304, and other circuits (not shown). The major difference between the semiconductor devices 300 and 600 is that the transistor D2 of the power regulator circuit 102 in the semiconductor device 600 is not protected by a proposed noise isolation structure.

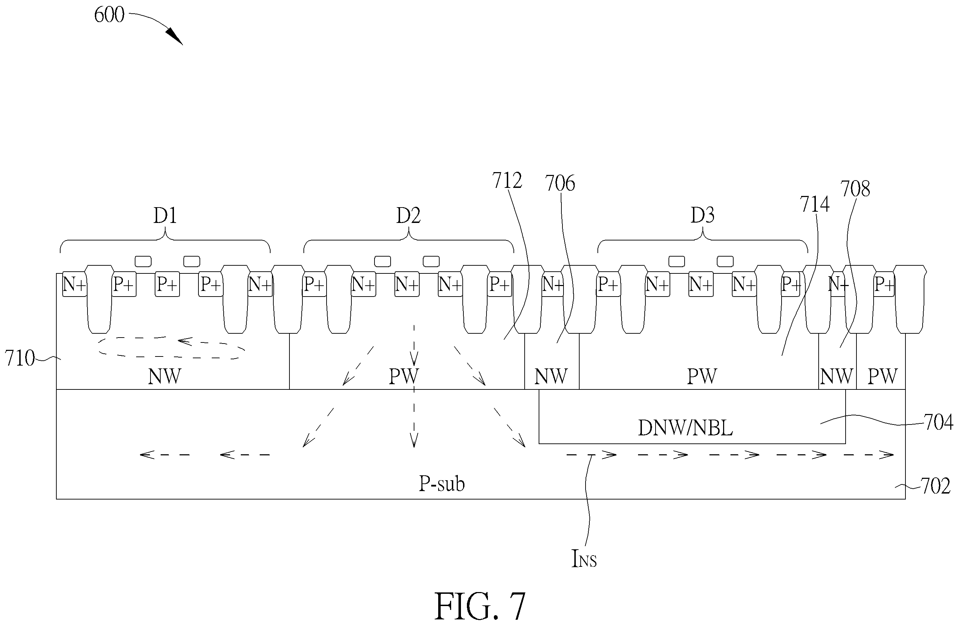

Please refer to FIG. 6 in conjunction with FIG. 7. FIG. 7 is a diagram illustrating a cross section of a semiconductor structure of the semiconductor device 600 shown in FIG. 6. FIG. 6 shows a top view of the noise isolation structure 308, while FIG. 7 shows a sectional view of the noise isolation structure 308. As shown in FIG. 7, the semiconductor device 600 has a P-type substrate (denoted by "P-Sub") 702, an isolation region (denoted by "DNW/NBL") 704 formed within the P-type substrate 702, a plurality of N-well walls (denoted by "NW") 706, 708, an N-well (denoted by "NW") 710 formed on the P-type substrate 702, and a plurality of P-wells (denoted by "PW") 712, 714 formed on the P-type substrate 702. The isolation region 704 may be a deep N-well or an N-type buried layer, depending upon the actual semiconductor process considerations. The transistor D1 is a PMOS transistor formed on the N-well 710. The transistor D2 is an NMOS transistor formed on the P-well 712. The transistor D3 is an NMOS transistor formed on the P-well 714.

In accordance with the semiconductor structure, the isolation region ISO2 of the transistor D3 is realized by the isolation region 704. The P-well 714 is formed on the isolation region 704, and is surrounded by N-well walls W21-W24, where the N-well wall 706 shown in FIG. 7 is one of the N-well walls W21-W24 shown in FIG. 6, and the N-well wall 708 shown in FIG. 7 is another of the N-well walls W21-W24 shown in FIG. 6. Hence, the transistor D3 is formed on a region (i.e., P-well 714) wrapped in the isolation region 704 and the N-well walls W21-W24.

The transistor D2 causes noisy current I_{NS} due to the switching frequency of the power regulator circuit 102. Since the transistor D2 is not protected by the proposed noise isolation structure 306, the noisy current I_{NS} flows through the P-well 712 and the P-type substrate 702. Since the transistor D3 is protected by the noise isolation structure 308 due to the P-well 714 wrapped in the isolation region 704 and the N-well walls W21-W24, the noisy current I_{NS} that leaks to the P-well 712 and the P-type substrate 702 is blocked from entering the P-well 714 where the transistor D3 is located. In this way, suboptimal ESD false-triggering prevention can be achieved by the noise isolation structure 308 implemented in the semiconductor structure shown in FIG. 7.

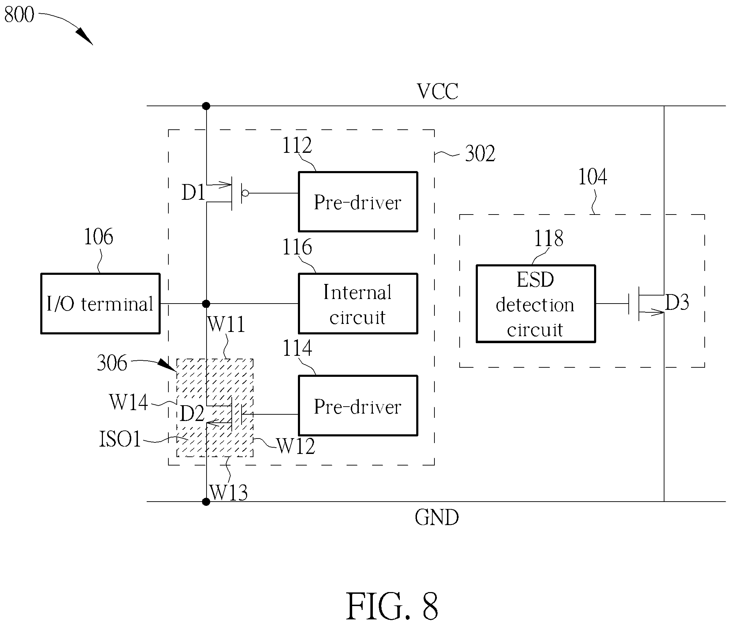

FIG. 8 is a diagram illustrating a third semiconductor device with noise isolation between a power regulator circuit and an ESD clamp circuit according to an embodiment of the present invention. The semiconductor device 800 is a semiconductor chip including the power regulator circuit 302, the ESD clamp circuit 104, and other circuits (not shown). The major difference between the semiconductor devices 300 and 800 is that the transistor D1 of the ESD clamp circuit 104 in the semiconductor device 800 is not protected by a proposed noise isolation structure.

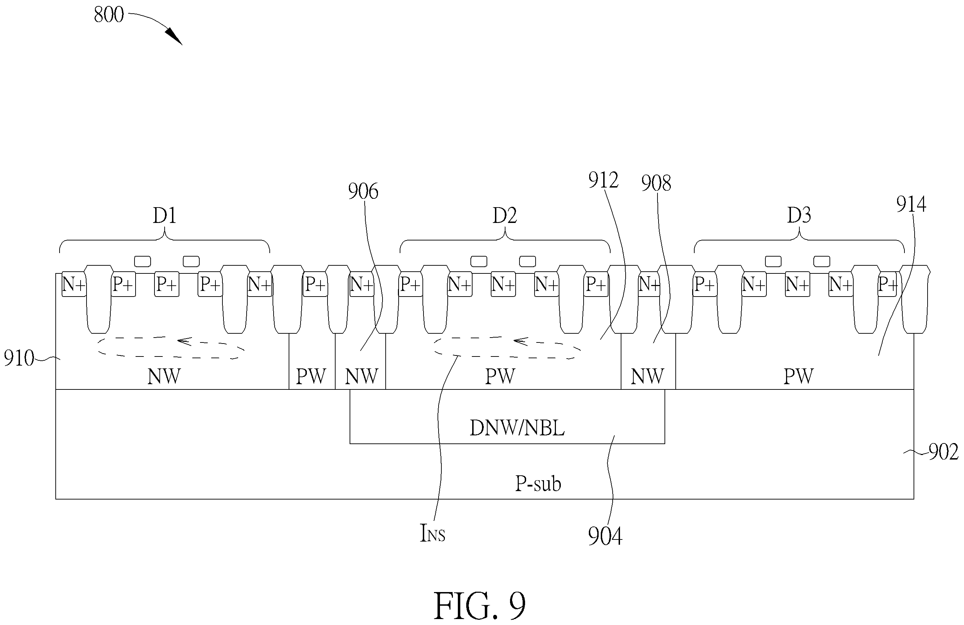

Please refer to FIG. 8 in conjunction with FIG. 9. FIG. 9 is a diagram illustrating a cross section of a semiconductor structure of the semiconductor device 800 shown in FIG. 8. FIG. 7 shows a top view of the noise isolation structure 306, while FIG. 9 shows a sectional view of the noise isolation structure 306. As shown in FIG. 9, the semiconductor device 800 has a P-type substrate (denoted by "P-Sub") 902, an isolation region (denoted by "DNW/NBL") 904 formed within the P-type substrate 902, a plurality of N-well walls (denoted by "NW") 906, 908, an N-well (denoted by "NW") 910 formed on the P-type substrate 902, and a plurality of P-wells (denoted by "PW") 91 2, 914 formed on the P-type substrate 902. The isolation region 904 may be a deep N-well or an N-type buried layer, depending upon the actual semiconductor process considerations. The transistor D1 is a PMOS transistor formed on the N-well 910. The transistor D2 is an NMOS transistor formed on the P-well 912. The transistor D3 is an NMOS transistor formed on the P-well 914.

In accordance with the semiconductor structure, the isolation region ISOl of the transistor D2 is realized by the isolation region 904. The P-well 912 is formed on the isolation region 904, and is surrounded by N-well walls W11-W1 4, where the N-well wall 906 shown in FIG. 9 is one of the N-well walls W11-W14 shown in FIG. 8, and the N-well wall 908 shown in FIG. 9 is another of the N-well walls W11-W14 shown in FIG. 8. Hence, the transistor D2 is formed on a region (i.e., P-well 912) wrapped in the isolation region 904 and the N-well walls W11-W14.

The transistor D2 causes noisy current I_{NS} due to the switching frequency of the power regulator circuit 302. Since the transistor D2 is protected by the noise isolation structure 306 due to the P-well 912 wrapped in the isolation region 904 and the N-well walls W11-W14, the noisy current I_{NS} is locked within the P-well 912 without leaking to the P-type substrate 902 and the P-well 914. In this way, suboptimal ESD false-triggering prevention can be achieved by the noise isolation structure 306 implemented in the semiconductor structure shown in FIG. 9.

Regarding each of the ESD clamp circuit 304 shown in FIG. 3/FIG. 6 and the ESD clamp circuit 104 shown in FIG. 8, the clamping component is implemented by the NMOS transistor D3. However, this is for illustrative purposes only, and is not meant to be a limitation of the present invention. In practice, the clamping component of the ESD clamp circuit 104/304 may be implemented by a metal-oxide-semiconductor field-effect transistor, a bipolar junction transistor (BJT), a silicon controlled rectifier (SCR), a field oxide device (FOD), or any feasible ESD protection device.

Furthermore, the circuit structures and semiconductor structures of the power regulator circuits 102 and 302 are for illustrative purposes only, and are not meant to be limitations of the present invention. Alternatively, the power regulator circuit 102 may be modified to have a different circuit structure and a different semiconductor structure, and/or the power regulator circuit 302 may be modified to have a different circuit structure and a different semiconductor structure. These alternative designs of the semiconductor device all fall within the scope of the present invention.

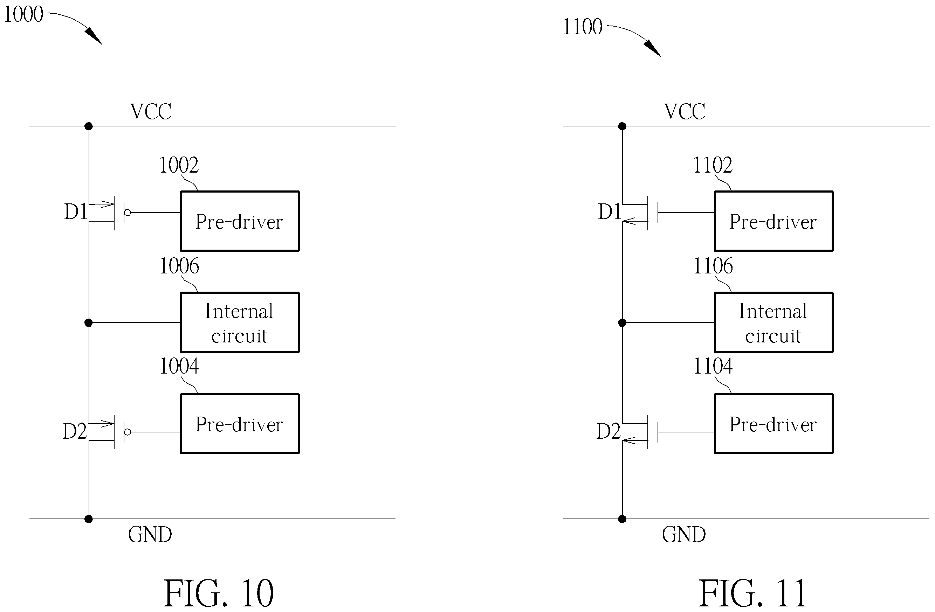

FIG. 10 is a diagram illustrating a first alternative design of a power regulator circuit according to an embodiment of the present invention. The power regulator circuit 1000 may be an LDO circuit. As shown in FIG. 10, the power regulator circuit 1000 includes output stages (which are implemented by transistors D1 and D2), driving circuits (e.g., pre-drivers 1002 and 1004), and an internal circuit 1006. In this example, both of the transistors D1 and D2 are PMOS transistors. Regarding the transistor D1, a source terminal is coupled to a power rail VCC, a gate terminal is coupled to the pre-driver 1002, and a drain terminal is coupled to the internal circuit 1006. Regarding the transistor D2, a source terminal is coupled to the internal circuit 1006, a gate terminal is coupled to the pre-driver 1004, and a drain terminal is coupled to a power rail GND. The power rail VCC is used to provide a supply voltage, and the power rail GND is used to provide a ground voltage. None of the transistors D1 and D2 included in the power regulator circuit 1000 is protected by a proposed noise isolation structure composed of an isolation region and N-well walls. In some embodiments of the present invention, the semiconductor device 600 shown in FIG. 6 may be modified to have the power regulator circuit 102 replaced with the power regulator circuit 1000.

FIG. 11 is a diagram illustrating a second alternative design of a power regulator circuit according to an embodiment of the present invention. The power regulator circuit 1100 may be an LDO circuit. As shown in FIG. 11, the power regulator circuit 1100 includes output stages (which are implemented by transistors D1 and D2), driving circuits (e.g., pre-drivers 1102 and 1104), and an internal circuit 1106. In this example, both of the transistors D1 and D2 are NMOS transistors. Regarding the transistor D1, a drain terminal is coupled to a power rail VCC, a gate terminal is coupled to the pre-driver 1202, and a source terminal is coupled to the internal circuit 1106. Regarding the transistor D2, a drain terminal is coupled to the internal circuit 1106, a gate terminal is coupled to the pre-driver 1104, and a source terminal is coupled to a power rail GND. The power rail VCC is used to provide a supply voltage, and the power rail GND is used to provide a ground voltage. None of the transistors D1 and D2 included in the power regulator circuit 1100 is protected by a proposed noise isolation structure composed of an isolation region and N-well walls. In some embodiments of the present invention, the semiconductor device 600 shown in FIG. 6 may be modified to have the power regulator circuit 102 replaced with the power regulator circuit 1100.

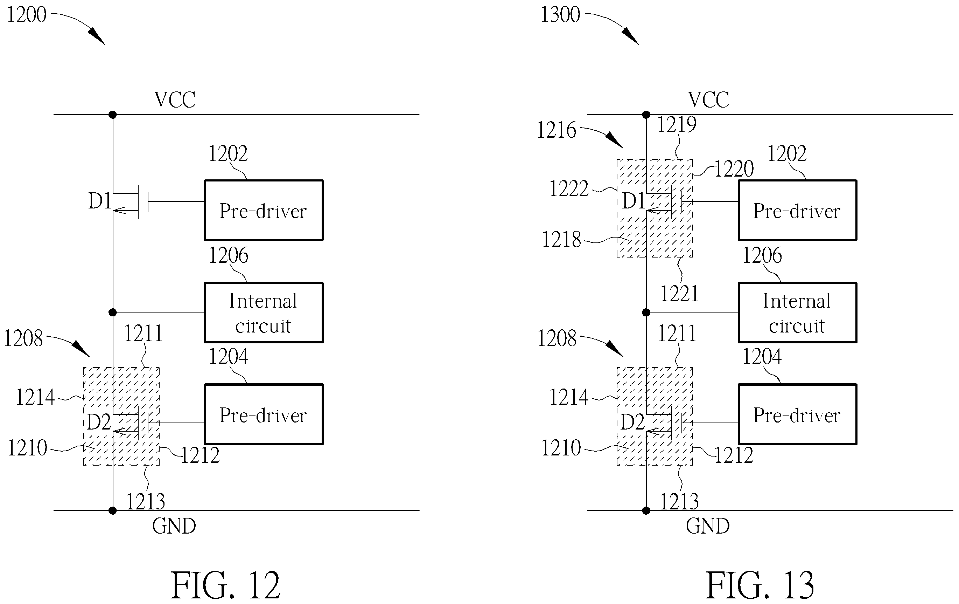

FIG. 12 is a diagram illustrating a third alternative design of a power regulator circuit according to an embodiment of the present invention. The power regulator circuit 1200 may be an LDO circuit. As shown in FIG. 12, the power regulator circuit 1200 includes output stages (which are implemented by transistors D1 and D2), driving circuits (e.g., pre-drivers 1202 and 1204), and an internal circuit 1206. In this example, both of the transistors D1 and D2 are NMOS transistors. Regarding the transistor D1, a drain terminal is coupled to a power rail VCC, a gate terminal is coupled to the pre-driver 1202, and a source terminal is coupled to the internal circuit 1206. Regarding the transistor D2, a drain terminal is coupled to the internal circuit 1206, a gate terminal is coupled to the pre-driver 1204, and a source terminal is coupled to a power rail GND. The power rail VCC is used to provide a supply voltage, and the power rail GND is used to provide a ground voltage. The transistor D1 included in the power regulator circuit 1200 is not protected by a proposed noise isolation structure composed of an isolation region and N-well walls, while the transistor D2 included in the power regulator circuit 1200 is protected by a proposed noise isolation structure 1208 composed of an isolation region 1210 and N-well walls 1211, 1212, 1213, 1214. A semiconductor structure of the noise isolation structure 1208 may be the same as that of the aforementioned noise isolation structure 306/308. Hence, the transistor D2 is an NMOS transistor formed on a region (e.g., P-well) wrapped in the isolation region 1210 and N-well walls 1211-1214. In some embodiments of the present invention, the semiconductor device 300 shown in FIG. 3 (or the semiconductor device 800 shown in FIG. 8) may be modified to have the power regulator circuit 302 replaced with the power regulator circuit 1200.

FIG. 13 is a diagram illustrating a fourth alternative design of a power regulator circuit according to an embodiment of the present invention. The power regulator circuit 1300 may be an LDO circuit. The major difference between the power regulator circuits 1200 and 1300 is that the transistor D1 of the power regulator circuit 1300 is protected by a proposed noise isolation structure 1216 composed of an isolation region 1218 and N-well walls 1219, 1220, 1221, 1222. A semiconductor structure of the noise isolation structure 1216 may be the same as that of the aforementioned noise isolation structure 306/308. Hence, the transistor D1 is an NMOS transistor formed on a region (e.g., P-well) wrapped in the isolation region 1218 and N-well walls 1219-1222. In some embodiments of the present invention, the semiconductor device 300 shown in FIG. 3 (or the semiconductor device 800 shown in FIG. 8) may be modified to have the power regulator circuit 302 replaced with the power regulator circuit 1300.

Regarding each of the power regulator circuits 102, 302, 1000, 1100, 1200, and 1300, one output stage includes a single transistor only. However, this is for illustrative purposes only, and is not meant to be a limitation of the present invention. Alternatively, an output stage may be implemented by a stack of N transistors, where N ≧ 2.

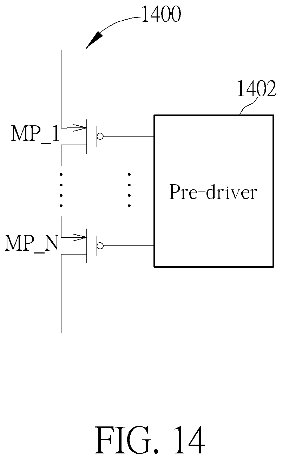

FIG. 14 is a diagram illustrating a first alternative design of an output stage used by a power regulator circuit according to an embodiment of the present invention. The output stage 1400 includes multiple transistors MP_1-MP_N that are series-connected, where N ≧ 2. In this example, each of the transistors MP_1 -MP_N is a PMOS transistor with a gate terminal coupled to a driving circuit (e.g., pre-driver 1402). Further, none of the transistors MP_1-MP_N is protected by a proposed noise isolation structure composed of an isolation region and N-well walls. In some embodiments of the present invention, the power-regulator circuit 302 of the semiconductor device 300 (or the power-regulator circuit 302 of the semiconductor device 800) may be modified to have the transistor D1 replaced with the series-connected transistors MP_1-MP_N shown in FIG. 14 and the pre-driver 112 replaced with the pre-driver 1402 shown in FIG. 14. Furthermore, in some embodiments of the present invention, the power-regulator circuit 102 of the semiconductor device 600 may be modified to have the transistor D1 replaced with the series-connected transistors MP_1-MP_N shown in FIG. 14 and the pre-driver 112 replaced with the pre-driver 1402 shown in FIG. 14.

FIG. 1 5 is a diagram illustrating a second alternative design of an output stage used by a power regulator circuit according to an embodiment of the present invention. The output stage 1500 includes multiple transistors MN_1-MN_N that are series-connected, where N ≧ 2. In this example, each of the transistors MN_1-MN_N is an NMOS transistor with a gate terminal coupled to a driving circuit (e.g., pre-driver 1502). Further, none of the transistors MN_1 -MN_N is protected by a proposed noise isolation structure composed of an isolation region and N-well walls. In some embodiments of the present invention, the power-regulator circuit 102 of the semiconductor device 600 may be modified to have the transistor D2 replaced with the series-connected transistors MN_1-MN_N shown in FIG. 15 and the pre-driver 114 replaced the pre-driver 1502 shown in FIG. 15.

FIG. 16 is a diagram illustrating a third alternative design of an output stage used by a power regulator circuit according to an embodiment of the present invention. The major difference between the output stages 1500 and 1600 is that the series-connected transistors MN_1-MN_N of the output stage 1600 is protected by a proposed noise isolation structure composed of an isolation region 1602 and N-well walls 1603, 1604, 1605, 1606. Specifically, the series-connected transistors MN_1-MN_N are NMOS transistors all formed on a region (i.e., P-well) wrapped in the isolation region 1602 and N-well walls 1603-1606. In some embodiments of the present invention, the power-regulator circuit 302 of the semiconductor device 300 (or the power-regulator circuit 302 of the semiconductor device 800) may be modified to have the transistor D2 replaced with the noise-isolated series-connected transistors MN_1-MN_N shown in FIG. 16 and the pre-driver 114 replaced the pre-driver 1502 shown in FIG. 16.

In above embodiments, an output stage may be implemented by using one or more metal-oxide-semiconductor field-effect transistors. However, this is for illustrative purposes only, and is not meant to be a limitation of the present invention. Alternatively, an output stage may be implemented by using one or more bipolar junction transistors (BJTs).

FIG. 17 is a diagram illustrating a fifth alternative design of a power regulator circuit according to an embodiment of the present invention. The power regulator circuit 1700 may be an LDO circuit. As shown in FIG. 17, the power regulator circuit 1700 includes output stages (which are implemented by transistors Q1 and Q2), driving circuits (e.g., pre-drivers 1702 and 1704), and an internal circuit 1706. In this example, the transistor Q1 is a PNP-type BJT, and the transistor Q2 is an NPN-type BJT. Regarding the transistor Q1, an emitter terminal is coupled to a power rail VCC, a base terminal is coupled to the pre-driver 1702, and a collector terminal is coupled to the internal circuit 1706. Regarding the transistor Q2, a collector terminal is coupled to the internal circuit 1706, a base terminal is coupled to the pre-driver 1704, and an emitter terminal is coupled to a power rail GND. The power rail VCC is used to provide a supply voltage, and the power rail GND is used to provide a ground voltage. None of the transistors Q1 and Q2 included in the power regulator circuit 1700 is protected by a proposed noise isolation structure composed of an isolation region and N-well walls. In some embodiments of the present invention, the semiconductor device 600 shown in FIG. 6 may be modified to have the power regulator circuit 102 replaced with the power regulator circuit 1700.

FIG. 18 is a diagram illustrating a sixth alternative design of a power regulator circuit according to an embodiment of the present invention. The major difference between the power regulator circuits 1700 and 1800 is that the transistor Q2 of the power regulator circuit 1800 is protected by a proposed noise isolation structure 1808 composed of an isolation region 1810 and N-well walls 1811, 1812, 1813, 1814. A semiconductor structure of the noise isolation structure 1808 may be the same as that of the aforementioned noise isolation structure 306/308. Hence, the transistor Q2 is formed on a region wrapped in the isolation region 1810 and N-well walls 1811-1814. In some embodiments of the present invention, the semiconductor device 300 shown in FIG. 3 (or the semiconductor device 800 shown in FIG. 8) may be modified to have the power regulator circuit 302 replaced with the power regulator circuit 1800.

In above embodiments, a power regulator circuit has two output stages, including one output stage coupled between a first power rail and an I/O terminal and another output stage coupled between the I/O terminal and a second power rail. However, this is for illustrative purposes only, and is not meant to be a limitation of the present invention. For example, a semiconductor device may be configured to employ an LDO circuit with an open drain topology or an LDO circuit with a current sink topology. In a first alternative design, the semiconductor device 300 shown in FIG. 3 may be modified by omitting the transistor D1 and the pre-driver 112. In a second alternative design, the semiconductor device 300 shown in FIG. 3 may be modified by omitting the transistor D2 (with the noise isolation structure 306) and the pre-driver 114. In a third alternative design, the semiconductor device 600 shown in FIG. 6 may be modified by omitting the transistor D1 and the pre-driver 112. In a fourth alternative design, the semiconductor device 600 shown in FIG. 6 may be modified by omitting the transistor D2 and the pre-driver 114. In a fifth alternative design, the semiconductor device 800 shown in FIG. 8 may be modified by omitting the transistor D1 and the pre-driver 112. In a sixth alternative design, the semiconductor device 800 shown in FIG. 8 may be modified by omitting the transistor D2 (with the noise isolation structure 306) and the pre-driver 114.

In above embodiments, a semiconductor device has one ESD clamp circuit (e.g., 104/304) coupled between two power rails VCC and GND. However, this is for illustrative purposes only, and is not meant to be a limitation of the present invention. Alternatively, a semiconductor device may be configured to have one ESD clamp circuit coupled between two power rails, and/or at least one ESD clamp circuit coupled between an I/O terminal and one of the power rails.

FIG. 19 is a diagram illustrating a first semiconductor device having at least one ESD clamp circuit coupled between an I/O terminal and a power rail according to an embodiment of the present invention. The semiconductor device 1900 is a semiconductor chip including two ESD clamp circuits 1902 and 1904, and other circuits (not shown), where an I/O terminal 1906 is an I/O pad of the semiconductor chip. The ESD clamp circuits 1902 and 1904 are implemented in the semiconductor chip for ESD protection. Specifically, each of the ESD clamp circuits 1902 and 1904 is arranged to discharge ESD current upon detection of an ESD event. As shown in FIG. 19, the ESD clamp circuit 1902 includes an ESD detection circuit 1908 and a clamping component 1910, and the ESD clamp circuit 1904 includes an ESD detection circuit 1912 and a clamping component 1914. The clamping component 1910/1914 may be implemented by a metal-oxide-semiconductor field-effect transistor, a bipolar junction transistor (BJT), a silicon controlled rectifier (SCR), a field oxide device (FOD), or any feasible ESD protection device.

In this embodiment, the clamping component 1910 is coupled between a power rail VCC and the I/O terminal 1906, and the clamping component 1914 is coupled between the I/O terminal 1906 and a power rail GND, where the power rail VCC is used to provide a supply voltage, and the power rail GND is used to provide a ground voltage. When an ESD event is detected by the ESD detection circuit 1908, the ESD detection circuit 1908 triggers the clamping component 1910, such that the clamping component 1910 is turned on to provide a discharge path between the power rail VCC and the I/O terminal 1906 for conducting the ESD current. Similarly, when an ESD event is detected by the ESD detection circuit 1912, the ESD detection circuit 1912 triggers the clamping component 1914, such that the clamping component 1914 is turned on to provide a discharge path between the I/O terminal 1906 and the power rail GND for conducting the ESD current. In this example, none of the clamping components 1910 and 1914 is protected by a proposed noise isolation structure composed of an isolation region and N-well walls.

In some embodiments of the present invention, any of the semiconductor devices 300, 600, 800 may be modified to include the ESD clamp circuits 1902 and 1904, where the ESD clamp circuit 1902 is coupled between the power rail VCC and the I/O terminal 106 of the semiconductor device 300/600/800, and the ESD clamp circuit 1904 is coupled between the I/O terminal 106 and the power rail GND of the semiconductor device 300/600/800.

FIG. 20 is a diagram illustrating a second semiconductor device having at least one ESD clamp circuit coupled between an I/O terminal and a power rail according to an embodiment of the present invention. The major difference between the semiconductor devices 1900 and 2000 is that the clamping component 1910 of the ESD clamp circuit 2002 is protected by a proposed noise isolation structure 2006 composed of an isolation region 2008 and N-well walls 2010, 2011, 2012, 2013, and the clamping component 1914 of the ESD clamp circuit 2004 is protected by a proposed noise isolation structure 2014 composed of an isolation region 2016 and N-well walls 2018, 2019, 2020, 2021. A semiconductor structure of the noise isolation structure 2006/2014 may be the same as that of the aforementioned noise isolation structure 306/308. Hence, the clamping component 1910 is formed on a region wrapped in the isolation region 2008 and N-well walls 2010-2013, and the clamping component 1910 is formed on a region wrapped in the isolation region 2016 and N-well walls 2018-2021.

In some embodiments of the present invention, any of the semiconductor devices 300, 600, 800 may be modified to include the ESD clamp circuits 2002 and 2004, where the ESD clamp circuit 2002 is coupled between the power rail VCC and the I/O terminal 106 of the semiconductor device 300/600/800, and the ESD clamp circuit 2004 is coupled between the I/O terminal 106 and the power rail GND of the semiconductor device 300/600/800.

Those skilled in the art will readily observe that numerous modifications and alterations of the device and method may be made while retaining the teachings of the invention. Accordingly, the above disclosure should be construed as limited only by the metes and bounds of the appended claims.

The present invention may also be defined by means of the following numbered clauses:
1. A semiconductor device comprising:
   a P-type substrate;
   a first isolation region, formed within the P-type substrate;
   a plurality of first N-well walls; and
   an electrostatic discharge (ESD) clamp circuit, arranged to discharge ESD current upon detection of an ESD event, wherein the ESD clamp circuit comprises:
      a clamping component, arranged to provide a discharge path for the ESD current, wherein the clamping component is formed on a region wrapped in the first isolation layer and the first N-well walls.
2. The semiconductor device of clause 1, further comprising:
   a plurality of second N-well walls; and
   a first active component, formed on another region that is wrapped in the first isolation layer, the second N-well walls, and at least one of the first N-well walls.
3. The semiconductor device of clause 2, wherein the first active component is a part of a power regulator circuit that is arranged to generate a regulated voltage output.
4. The semiconductor device of clause 3, further comprising:
   a second active component, formed on said another region wrapped in the first isolation layer, the second N-well walls, and said at least one of the first N-well walls, wherein the second active component is another part of the power regulator circuit, and the first active component and the second active component are series-connected between an input/output (I/O) terminal and a power rail.
5. The semiconductor device of clause 3, wherein the first active component is a transistor coupled between an input/output (I/O) terminal and a power rail.
6. The semiconductor device of clause 5, wherein the transistor is an N-channel metal-oxide-semiconductor field-effect transistor.
7. The semiconductor device of clause 5, wherein the transistor is an NPN-type bipolar junction transistor.
8. The semiconductor device of clause 1, further comprising:
   a second isolation region, formed within the P-type substrate;
   a plurality of second N-well walls; and
   a first active component, formed on another region wrapped in the second isolation layer and the second N-well walls.
9. The semiconductor device of clause 8, wherein the first active component is a part of a power regulator circuit that is arranged to generate a regulated voltage output.
10. The semiconductor device of clause 9, further comprising:
   a second active component, formed on said another region wrapped in the second isolation layer and the second N-well walls, wherein the second active component is another part of the power regulator circuit, and the first active component and the second active component are series-connected between an input/output (I/O) terminal and a power rail.
11. The semiconductor device of clause 9, wherein the first active component is a transistor coupled between an input/output (I/O) terminal and a power rail.
12. The semiconductor device of clause 11, wherein the transistor is an N-channel metal-oxide-semiconductor field-effect transistor.
13. The semiconductor device of clause 11, wherein the transistor is an NPN-type bipolar junction transistor.
14. The semiconductor device of clause 1, wherein the ESD clamp circuit is coupled between a first power rail and a second power rail.
15. The semiconductor device of clause 1, wherein the ESD clamp circuit is coupled between an input/output (I/O) terminal and a power rail.
16. A semiconductor device comprising:
   a P-type substrate;
   an isolation region, formed within the P-type substrate;
   a plurality of N-well walls; and
   a power regulator circuit, arranged to generate a regulated voltage output, wherein the power regulator circuit comprises:
      an active component, formed on a region wrapped in the isolation layer and the N-well walls.
17. The semiconductor device of clause 16, wherein the active component is a transistor coupled between an input/output (I/O) terminal and a power rail.
18. The semiconductor device of clause 17, wherein the transistor is an N-channel metal-oxide-semiconductor field-effect transistor.
19. The semiconductor device of clause 17, wherein the transistor is an NPN-type bipolar junction transistor.

## Claims

1. A semiconductor device (100, 300, 600, 800) comprising:
a P-type substrate (202, 402, 502, 702, 902);
a first isolation region, formed within the P-type substrate (202, 402, 502, 702, 902);
a plurality of first N-well walls; and
an electrostatic discharge, ESD, clamp circuit (104, 304 1902, 1904, 2002, 2004), arranged to discharge ESD current upon detection of an ESD event, wherein the ESD clamp circuit (104, 304 1902, 1904, 2002, 2004)comprises:
a clamping component (1910, 1914), arranged to provide a discharge path for the ESD current, wherein the clamping component (1910, 1914) is formed on a region wrapped in the first isolation layer and the first N-well walls.

2. The semiconductor device of (100, 300, 600, 800) claim 1, further comprising:
a plurality of second N-well walls; and
a first active component, formed on another region that is wrapped in the first isolation layer, the second N-well walls, and at least one of the first N-well walls.

3. The semiconductor device (100, 300, 600, 800) of claim 2, wherein the first active component is a part of a power regulator circuit that is arranged to generate a regulated voltage output.

4. The semiconductor device (100, 300, 600, 800) of claim 3, further comprising:
a second active component, formed on said another region wrapped in the first isolation layer, the second N-well walls, and said at least one of the first N-well walls, wherein the second active component is another part of the power regulator circuit, and the first active component and the second active component are series-connected between an input/output, I/O, terminal and a power rail.

5. The semiconductor device of (100, 300, 600, 800) claim 3, wherein the first active component is a transistor coupled between an input/output, I/O, terminal and a power rail.

6. The semiconductor device (100, 300, 600, 800) of claim 5, wherein the transistor is an N-channel metal-oxide-semiconductor field-effect transistor; or
wherein the transistor is an NPN-type bipolar junction transistor.

7. The semiconductor device (100, 300, 600, 800) of claim 1, further comprising:
a second isolation region, formed within the P-type substrate (202, 402, 502, 702, 902);
a plurality of second N-well walls; and
a first active component, formed on another region wrapped in the second isolation layer and the second N-well walls.

8. The semiconductor device (100, 300, 600, 800) of claim 7, wherein the first active component is a part of a power regulator circuit that is arranged to generate a regulated voltage output.

9. The semiconductor device (100, 300, 600, 800) of claim 8, further comprising:
a second active component, formed on said another region wrapped in the second isolation layer and the second N-well walls, wherein the second active component is another part of the power regulator circuit, and the first active component and the second active component are series-connected between an input/output, I/O, terminal and a power rail.

10. The semiconductor device (100, 300, 600, 800) of claim 8, wherein the first active component is a transistor coupled between an input/output, I/O, terminal and a power rail.

11. The semiconductor device (100, 300, 600, 800) of claim 10, wherein the transistor is an N-channel metal-oxide-semiconductor field-effect transistor; or
wherein the transistor is an NPN-type bipolar junction transistor.

12. The semiconductor device (100, 300, 600, 800) of claim 1, wherein the ESD clamp circuit (104, 304 1902, 1904, 2002, 2004) is coupled between a first power rail and a second power rail; or
wherein the ESD clamp circuit (104, 304 1902, 1904, 2002, 2004) is coupled between an input/output, I/O, terminal and a power rail.

13. A semiconductor device (100, 300, 600, 800) comprising:
a P-type substrate (202, 402, 502, 702, 902);
an isolation region, formed within the P-type substrate (202, 402, 502, 702, 902);
a plurality of N-well walls; and
a power regulator circuit, arranged to generate a regulated voltage output, wherein the power regulator circuit comprises:
an active component, formed on a region wrapped in the isolation layer and the N-well walls.

14. The semiconductor device (100, 300, 600, 800) of claim 13, wherein the active component is a transistor coupled between an input/output, I/O, terminal and a power rail.

15. The semiconductor device (100, 300, 600, 800) of claim 14, wherein the transistor is an N-channel metal-oxide-semiconductor field-effect transistor; or
wherein the transistor is an NPN-type bipolar junction transistor.
